# FASCICULE DE BREVET EUROPEEN

(11) **EP 3 754 849 B1**
(45) Date de publication et mention de la délivrance du brevet: **08.09.2021**
(21) Numéro de dépôt: 20180387.1
(22) Date de dépôt: 16.06.2020
(51) Int. Cl.: H03K 17/72, H02M 5/25, H02M 7/15, H03K 17/74

(54) **COMMANDE D'UN THYRISTOR**
STEUERUNG EINES THYRISTORS
CONTROL FOR A THYRISTOR

(30) Priorité: 17.06.2019 FR 1906487
(43) Date de publication de la demande: 23.12.2020
(73) Titulaire: STMicroelectronics Ltd, Kowloon 999077 (HK)
(72) Inventeur: GONTHIER, Laurent, 10462 TAIPEI CITY (TW); LIN, Gary, 111 TAIPEI (TW)
(74) Mandataire: Cabinet Beaumont

(56) Documents cités:
- JP-A- H04 168 976
- US-B1- 6 493 245

## Description

### Domaine technique

La présente description concerne de façon générale les circuits électroniques et plus particulièrement les circuits destinés à être reliés à une source de tension alternative, telle que le secteur du réseau de distribution d'électricité. La présente description s'applique plus particulièrement à la commande de thyristors d'un pont redresseur d'un convertisseur de puissance.

### Technique antérieure

De nombreuses applications utilisent un convertisseur de puissance, par exemple pour convertir l'énergie prélevée sur le réseau de distribution électrique en une tension utilisable par des circuits électriques ou électroniques. Ces convertisseurs effectuent le plus souvent un redressement de la tension alternative du secteur, pouvant être associée à une correction du facteur de puissance avant de fournir une tension continue à une charge. La charge est souvent elle-même un circuit de conversion continu-continu (DC/DC) ou continu-alternatif (DC/AC) de type alimentation à découpage.

On utilise de plus en plus souvent des ponts commandables ou des ponts mixtes qui permettent, une fois que le convertisseur est en régime établi, de court-circuiter une résistance de limitation du courant d'appel servant au démarrage.

La présence de commutateurs, typiquement des thyristors, dans un pont de redressement requiert classiquement, pour le demi-pont supérieur, une alimentation auxiliaire afin de commander les thyristors. Cela nécessite de générer une tension d'alimentation auxiliaire en plus de celle déjà nécessaire au circuit de correction du facteur de puissance en raison des références de tension différentes. Cela accroît l'encombrement et le coût du convertisseur.

Le document US 6,493,245 décrit un procédé et un dispositif pour contrôler le courant d'appel de convertisseur alternatif-vers continu.

Le document JP 04168976 décrit une alimentation en courant continu.

### Résumé de l'invention

Un mode de réalisation pallie tout ou partie des inconvénients des ponts mixtes ou des ponts commandables usuels.

Un mode de réalisation prévoit un circuit comportant :
un pont redresseur ayant au moins un premier thyristor en série avec un premier élément de redressement entre une première borne et une deuxième borne de sortie redressée du pont ; et
au moins une diode en série avec une source de tension continue entre une gâchette du thyristor et ladite deuxième borne.

Selon un mode de réalisation, le circuit comporte en outre un commutateur relié entre lesdites bornes de sortie.

Un mode de réalisation prévoit un procédé de commande d'un circuit tel que décrit, comportant une étape de mise en conduction du commutateur au rythme des alternances de la tension alternative.

Selon un mode de réalisation, le commutateur est mis en conduction au voisinage des passages par zéro d'une tension alternative appliquée à l'entrée du pont redresseur.

Selon un mode de réalisation, la mise en conduction du commutateur est déclenchée lorsque la tension alternative descend en dessous d'une valeur supérieure à la tension continue fournie par ladite source.

Selon un mode de réalisation, la mise en conduction du commutateur est déclenchée avec retard par rapport au moment où la tension alternative descend en dessous d'une valeur supérieure à la tension continue fournie par ladite source.

Selon un mode de réalisation, une première résistance relie une cathode de ladite diode à la gâchette dudit premier thyristor.

Selon un mode de réalisation, un deuxième thyristor du pont redresseur, en série avec un deuxième élément de redressement entre lesdites bornes de sortie, a sa gâchette reliée à ladite diode par l'intermédiaire d'une deuxième résistance.

Selon un mode de réalisation, un circuit de correction du facteur de puissance est relié auxdites bornes de sortie.

Selon un mode de réalisation, un condensateur relie lesdites bornes de sortie du pont.

Selon un mode de réalisation, une résistance de limitation du courant d'appel est court-circuitable par ledit ou lesdits thyristors.

Selon un mode de réalisation, un condensateur alternatif relie deux bornes d'entrée du pont redresseur.

Selon un mode de réalisation, un circuit de décharge adapté à décharger le condensateur alternatif par l'intermédiaire d'au moins le commutateur est mis en conduction lorsqu'une déconnection de la tension alternative est détectée.

Un mode de réalisation prévoit un convertisseur de puissance comportant un circuit tel que décrit.

Selon un mode de réalisation, le convertisseur comporte en outre un circuit de correction du facteur de puissance.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un exemple de convertisseur de puissance usuel ;
la figure 2 représente un mode de réalisation d'un convertisseur de puissance ;
la figure 3 représente un autre mode de réalisation d'un convertisseur de puissance ;
la figure 4 détaille un exemple de circuit de correction du facteur de puissance du convertisseur de la figure 3 ;
la figure 5 illustre, par des vues (A) et (B), le fonctionnement du convertisseur de la figure 3 dans une condition d'alimentation et de charge ;
la figure 6 illustre, par des vues (A) et (B), le fonctionnement du convertisseur de la figure 3 dans une autre condition d'alimentation et de charge ;
la figure 7 illustre, par des vues (A) et (B), le fonctionnement du convertisseur de la figure 3 dans une autre condition d'alimentation et de charge ;
la figure 8 illustre le fonctionnement du convertisseur de la figure 3 dans une autre condition d'alimentation et de charge ; et
la figure 9 représente une variante du convertisseur de puissance de la figure 3.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la génération des signaux de commande du circuit de correction du facteur de puissance n'a pas été détaillée, les modes de réalisation décrits étant compatibles avec les circuits usuels et les commandes usuelles de tels circuits.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

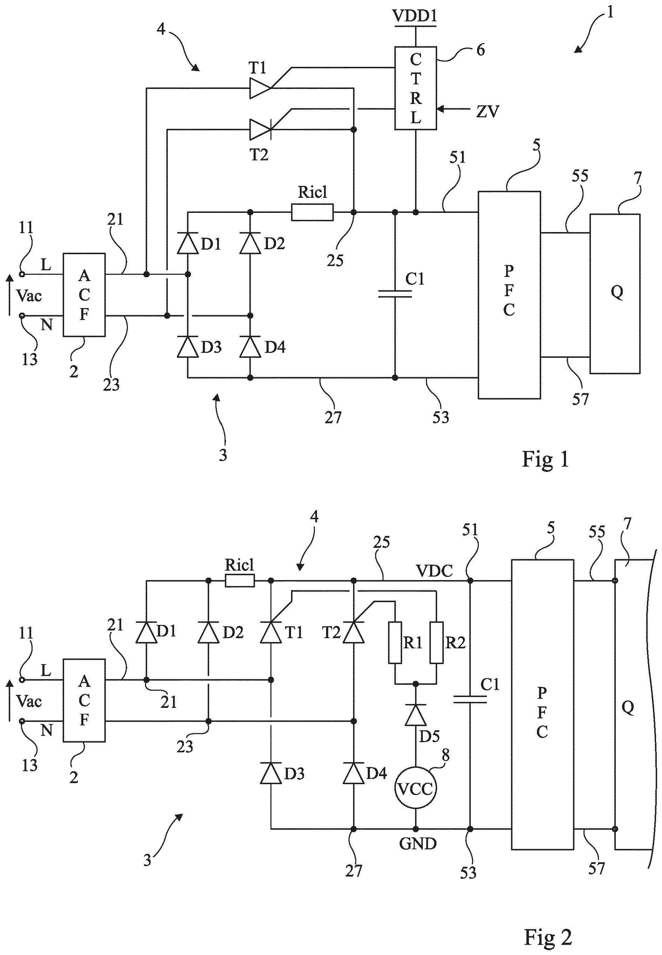

La figure 1 représente un exemple de convertisseur de puissance 1 usuel.

Un tel convertisseur 1 est basé sur un redressement mono ou double alternance d'une tension alternative Vac d'alimentation, suivi d'une correction du facteur de puissance (PFC) pour alimenter une charge (Q), le cas échéant avec conversion continu-continu (DC/DC) ou continu-alternatif (DC/AC).

Schématiquement, la tension alternative Vac est appliquée entre deux bornes d'entrée 11 (L) et 13 (N) reliées, généralement par l'intermédiaire d'un filtre alternatif 2 (ACF) ou filtre EMI, à des bornes 21 et 23 d'entrée alternative d'un pont redresseur 3. La tension Vac est, par exemple, la tension alternative ou tension secteur d'un réseau de distribution d'électricité 230V/50 ou 60 Hz ou 110V/50 ou 60 Hz. Typiquement, les bornes 11 et 13 sont constituées de broches d'une fiche de raccordement ou branchement du convertisseur 1 à une prise d'une installation électrique.

Des bornes de sortie redressée 25 et 27 du pont redresseur sont reliées à des bornes d'entrée 51 et 53 d'un circuit 5 (PFC) de correction du facteur de puissance. Des bornes 55 et 57 de sortie fournissent une tension d'alimentation à une charge 7 (Q). Un condensateur C1 relie, de préférence connecte, les bornes 25 et 27.

Dans les applications visées par la présente description, le convertisseur 1 comporte, outre le pont redresseur 3, au moins un demi-pont commandable 4.

Le pont redresseur 3, par exemple double alternance, est constitué de quatre branches reliant deux à deux chaque borne d'entrée à chaque borne de sortie, un élément de redressement (typiquement une diode) étant présent dans chaque branche.

Le demi-pont commandable 4 est un demi-pont redresseur dans lequel deux branches relient les deux bornes d'entrée 21 à 23 à la borne 51, un commutateur, typiquement un thyristor ou un SCR, étant présent dans chaque branche.

Un tel demi-pont équipe généralement les systèmes de conversion d'énergie en complément d'un pont non commandable afin de court-circuiter une résistance Ricl de limitation du courant d'appel, une fois que le système a démarré.

Selon les modes de réalisation décrits, le pont redresseur 3 est un pont double alternance associé à un demi-pont commandable 4, ou un pont mixte associé à un demi-pont à diodes, ce qui revient au même.

Dans l'exemple de la figure 1, le pont 3 comporte :
- deux diodes D1 et D2 reliant, de préférence connectant, respectivement les bornes 21 et 23 à une première borne de la résistance Ricl dont l'autre borne est reliée, de préférence connectée, à la borne 25, les anodes des diodes D1 et D2 étant côté bornes 21 et 23 ;
- deux diodes D3 et D4 reliant, de préférence connectant, respectivement les bornes 21 et 23 à la borne 27, les anodes des diodes D3 et D4 étant côté borne 27 ;
- deux thyristors T1 et T2, ici à gâchette de cathode, reliant, de préférence connectant, respectivement les bornes 21 et 23, à la borne 25, les anodes des thyristors étant côté bornes 21 et 23.

Au démarrage du circuit, c'est-à-dire lors de sa mise sous tension Vac, les thyristors T1 et T2 ne sont pas commandés et le redressement de la tension Vac passe par la résistance Ricl. Une fois que le circuit a démarré et est en régime établi, les thyristors T1 et T2 sont alternativement commandés selon l'alternance de la tension Vac et assurent la fonction de redressement du demi-pont supérieur. A chaque alternance, un seul des deux thyristors (celui qui est polarisé en direct) est passant. La commande des thyristors est impulsionnelle, c'est-à-dire que leurs gâchettes reçoivent une impulsion de courant à chaque alternance de la tension Vac. Par impulsion, on entend un signal d'une durée inférieure à la durée d'une alternance de la tension Vac, de préférence dans un rapport d'au moins 10. L'utilisation de thyristors permet de court-circuiter la résistance Ricl lorsque le système est en régime établi ainsi que de réaliser une commande en angle de phase.

Le circuit 5 de correction du facteur de puissance comporte, de façon usuelle, au moins un enroulement inductif (non représenté en figure 1) commuté à une fréquence nettement plus élevée (avec un rapport de l'ordre de 1000 à 10000) que la fréquence de la tension Vac. En variante, le circuit 5 est un circuit d'alimentation à découpage.

La présence des thyristors T1 et T2 dans la partie supérieure du pont requiert de pouvoir générer des courants de gâchette avec une référence de tension plus élevée que le potentiel de référence du convertisseur, à savoir le potentiel (masse) de la borne 27. En particulier, l'injection d'un courant dans les gâchettes de cathode des thyristors T1 et T2 requiert que les cathodes de ces thyristors soient à un potentiel inférieur au potentiel de leurs gâchettes G1 et G2. Les thyristors sont par exemple commandés par un circuit 6 (CTRL) de génération de courants de gâchette en fonction de l'alternance de la tension alternative Vac. Il est alors nécessaire de générer une basse tension VDD1 du circuit 6, positive référencée à la borne 25 pour alimenter le circuit 6. Typiquement, le circuit 6 reçoit une information ZV sur les passages par zéro de la tension d'entrée du pont pour générer les signaux de commande des gâchettes.

La génération de la tension VDD1 nécessite un transformateur (non représenté), généralement inductif, dont un enroulement primaire est en aval de la borne 25 et dont un enroulement secondaire génère la tension VDD1 référencée au potentiel de borne 25. Le besoin d'un tel transformateur est préjudiciable à l'encombrement, au coût et à la simplicité du convertisseur.

La figure 2 représente un mode de réalisation d'un convertisseur de puissance.

On retrouve :
- des bornes d'entrée 11 et 13 d'application d'une tension alternative d'alimentation Vac ;
- un pont redresseur 3, par exemple double alternance, dont des bornes d'entrée alternative 21 et 23 sont respectivement reliées aux bornes 11 et 13 ;
- un circuit 5 de correction du facteur de puissance (PFC) ou un convertisseur DC/DC ou DC/AC dont des bornes d'entrée 51 et 53 sont reliées, de préférence connectées, à des bornes de sortie 25 et 27 du pont 3 et dont des bornes de sortie 55 et 57 alimentent une charge 7 (Q) ;
- un demi-pont supérieur commandable 4 relié entre les bornes 21 et 23 et la borne 25 de sortie redressée positive, le demi-pont 4, servant à court-circuiter un demi-pont de diodes D1, D2 du pont 3, le demi-pont 4 étant associé à une résistance de limitation du courant d'appel Ricl ;
- optionnellement un filtre alternatif 2 entre les bornes 11 et 13 et les bornes 21 et 23 ; et
- optionnellement, un condensateur C1 relié, de préférence connecté, aux bornes 25 et 27.

Dans l'exemple de la figure 2, la représentation prend la forme d'un pont mixte dont un demi-pont inférieur est constitué des diodes D3 et D4 et dont un demi-pont supérieur est constitué des thyristors T1 et T2, et d'un demi-pont supérieur de diodes D1 et D2 associé à la résistance Ricl.

Selon ce mode de réalisation, les gâchettes des thyristors T1 et T2 sont reliées, par l'intermédiaire de résistances respectives R1 et R2, à une cathode d'une diode D5 dont l'anode est reliée, de préférence connectée à une basse tension continue VCC (source 8) référencée à la masse 27 (GND). Par basse tension, on entend une tension inférieure à 30 volts, par exemple de l'ordre de 20 volts, voire moins.

Le rôle de ce montage est de provoquer, à chaque alternance de la tension Vac, lorsque la tension VDC de sortie du pont devient inférieure à la tension VCC (aux chutes de tension près dans la diode D5 à l'état passant et dans les résistances R1 et R2), la circulation d'un courant depuis la source de tension 8 à travers la diode D5, les résistances R1 et R2, les gâchettes des thyristors T1 et T2 et le condensateur C1. On utilise donc le condensateur C1 à chaque fin d'une alternance et début de la suivante pour permettre la circulation des courants de gâchette. La valeur de la tension VCC conditionne un seuil de tension autour du passage par zéro de la tension entre les bornes 51 et 53 pendant lequel ces courants circulent.

Ainsi, il n'est plus nécessaire de générer une tension référencée à la borne 25 pour commander les thyristors T1 et T2. La tension VCC peut en outre être aisément générée à partir de la tension VDC. En effet, il n'est pas gênant que cette tension ne soit pas présente au démarrage du système dans la mesure où les thyristors T1 et T2 n'ont besoin d'être commandés pour court-circuiter la résistance Ricl qu'une fois que le système est en régime établi.

Dans ce mode de réalisation simplifié, aucune commande n'est requise et les thyristors sont amorcés automatiquement. Il faut cependant que la décharge du condensateur C1 soit suffisante, et/ou que la charge consomme suffisamment en aval à l'approche du zéro de tension entre les bornes 11 et 13

(tension Vac) pour que le système fonctionne. Pour une charge de consommation stable, il suffit de dimensionner les résistances R1 et R2 ainsi que la diode D5 de façon adaptée pour fournir le courant de gâchette nécessaire à l'amorçage des thyristors T1 et T2. Toutefois, ce mode de réalisation n'est pas le mieux adapté à une charge variable très faible, pour laquelle le condensateur C1, s'il est présent dans le circuit, ne serait pas suffisamment déchargé. Ce qui revient au cas, si le condensateur C1 est absent, où l'impédance équivalente du circuit 5, vue entre les bornes 51 et 53, est très élevée.

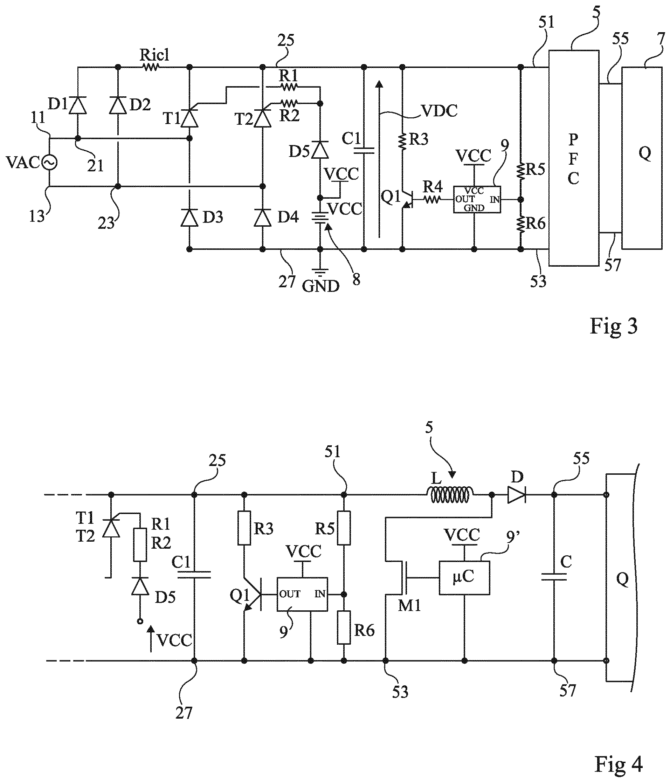

La figure 3 représente un autre mode de réalisation d'un convertisseur de puissance.

Selon ce mode de réalisation, le circuit de la figure 2 est complété par un montage forçant la décharge du condensateur C1 à chaque fin d'alternance afin de faciliter la circulation des courants de gâchette. Pour un circuit dépourvu de condensateur C1, ce circuit permet de forcer la conduction de la diode D5, afin de permettre la circulation des courants de gâchette dans les thyristors T1 et T2 dans le cas où les éléments en aval des bornes 51 et 53 présentent une impédance trop élevée pour engendrer une conduction du thyristor T1 ou T2 en début d'alternance.

Ainsi, on prévoit un commutateur Q1, par exemple un transistor bipolaire, en série avec une résistance R3, entre les bornes 25 et 27. Par exemple, l'émetteur d'un transistor bipolaire Q1 de type NPN est relié, de préférence connecté, à la masse 27. Le collecteur du transistor Q1 est relié, par la résistance R3, à la borne 25. La base ou borne de commande du transistor Q1 reçoit un signal de commande d'un circuit 9, par exemple via une résistance R4.

Le circuit 9 est, de préférence, alimenté par la tension VCC (entre les bornes VCC et GND) et génère un créneau ou impulsion de commande du transistor Q1 au voisinage de chaque passage par zéro de la tension redressée VDC. Par exemple, une entrée IN du circuit 9 est reliée, de préférence connectée, au point milieu d'une association en série de deux résistances R5 et R6 reliées, de préférence connectées, entre les bornes 25 et 27. Cette association en série constitue un pont diviseur de tension permettant de déclencher, au niveau du circuit 9, une commutation de sa sortie OUT entre un niveau haut et un niveau bas. Lorsque cette sortie OUT est au niveau haut, le transistor Q1 est rendu passant, ce qui force la décharge du condensateur C1, s'il est présent, par dissipation dans la résistance R3 et force la conduction de courant dans la diode D5, l'une des résistances R1 et R2 et l'un des thyristors T1 et T2 que le condensateur C1 soit présent ou non.

Le fonctionnement du montage dépend de la consommation de la charge connectée en aval du convertisseur. En effet, si la consommation de la charge est faible, le courant dans le pont, donc également dans les anodes des thyristors, va s'annuler avant que les courants de gâchette d'amorçage des thyristors aient été suffisants. Dans ce cas, la résistance Ricl n'est pas court-circuitée et dissipe de l'énergie à chaque alternance. Ainsi, la solution décrite est surtout avantageuse lorsque la charge connectée en aval du circuit 5 consomme un courant suffisant pour que les courants des thyristors T1 et T2 atteignent leur seuil de verrouillage à chaque début de demi-alternance. Cette notion de courant suffisant dépend de l'application mais est, par exemple, d'au moins 10 % de la puissance nominale de l'application.

La figure 4 détaille un exemple de circuit de correction du facteur de puissance du convertisseur de la figure 3.

La figure 4 est une représentation partielle. En particulier, le pont redresseur 3 n'est pas représenté et seule une branche du demi-pont 4 est représentée (thyristor T1 ou T2), associée à sa résistance de gâchette R1 ou R2.

Le circuit 5 de correction du facteur de puissance comporte, par exemple :
une inductance L en série avec une diode D entre les bornes 51 et 55 ;
un interrupteur M1, par exemple un transistor MOS, reliant, de préférence connectant, la borne 53 au point milieu de l'association en série de l'inductance L et de la diode D ;
un condensateur C de sortie reliant, de préférence connectant, les bornes 55 et 57 ; et
un circuit 9', par exemple un microcontrôleur (pC) de commande de l'interrupteur M1. Le microcontrôleur 9' est, par exemple, alimenté par la tension VCC ou par une tension extraite à partir de la tension VCC.

L'interrupteur M1 est commandé à une fréquence élevée par rapport à la fréquence de la tension Vac, avec un rapport d'au moins 1000 (par ex à une fréquence de quelques centaines de kHz). Le fonctionnement du circuit de correction du facteur de puissance 5 est en lui-même usuel.

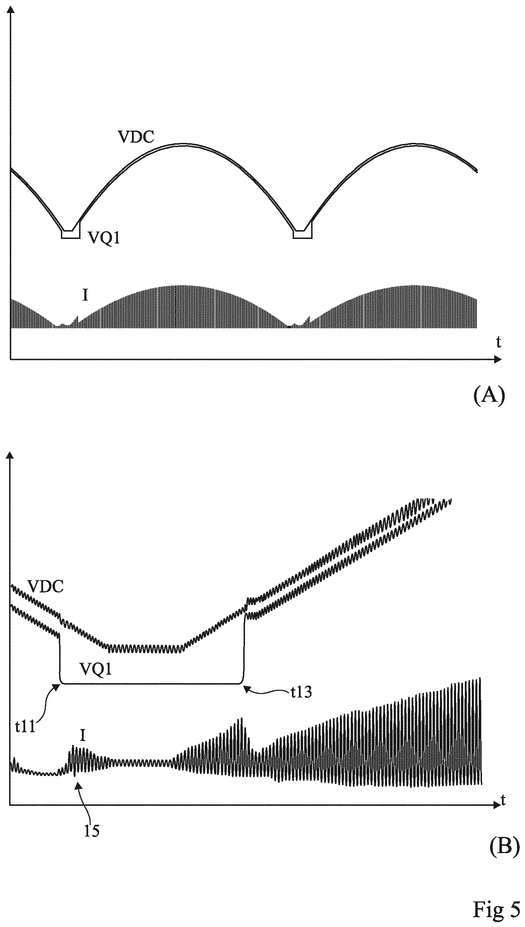

Les figures 5 à 8 illustrent, par des chronogrammes, le fonctionnement du montage de la figure 3 pour plusieurs tensions d'alimentation Vac et plusieurs niveaux de consommation de la charge alimentée par le convertisseur. Ces figures prennent pour exemple des situations défavorables pour le verrouillage de thyristors T1 et T2, à savoir un circuit de correction du facteur de puissance fonctionnant en mode courant discontinu dans lequel le courant dans l'inductance L (figure 4) s'annule à chaque période de commutation du transistor M1.

Ces figures représentent des exemples d'allures de la tension VDC aux bornes du condensateur C1, de la tension VQ1 aux bornes du commutateur Q1 (illustrant ses périodes de fermeture pendant lesquelles il décharge partiellement le condensateur C1), et du courant de cathode I dans le thyristor T1 ou T2 polarisé en direct (le transistor T1 pendant les alternances positives de la tension Vac et le transistor T2 pendant les alternances négatives de la tension Vac). La décharge du condensateur C1 s'effectue jusqu'à ce que le courant I atteigne le verrouillage du thyristor rendu passant.

La figure 5 illustre, par des vues (A) et (B), le fonctionnement du convertisseur de la figure 3 pour une tension Vac de 110 volts et une fréquence de 50 Hz, et une charge de 25 %, c'est-à-dire que la charge 7 absorbe une puissance égale à 25 % de la puissance nominale du convertisseur.

La vue (A) représente deux alternances de la tension Vac tandis que la vue (B) est un agrandissement au voisinage du passage par zéro de la tension VDC.

Comme l'illustrent ces chronogrammes, lorsque le circuit 9 détecte que la tension VDC descend en dessous d'un seuil conditionné par les résistances R5 et R6, par exemple en dessous de 20 volts, le transistor Q1 est rendu passant (instant t11, figure 5B). Le condensateur C1 se décharge et est maintenu au minimum au niveau de la tension VCC par la circulation depuis la source 8. Lors du début de l'alternance suivante, le courant de gâchette devient suffisant pour amorcer le thyristor T1 ou T2 et le courant I de cathode atteint le seuil de verrouillage du thyristor T1 ou T2. On notera que le courant I de la figure inclut le courant de gâchette qui circule depuis la gâchette jusqu'à la cathode (le courant de cathode I correspond à la somme du courant de gâchette et du courant de cathode). Lors de l'ouverture du commutateur Q1 (instant t13), le thyristor T1 ou T2 reste donc amorcé jusqu'à la fin de l'alternance. Comme l'illustre la partie gauche de la vue (B), aucun courant ne circule dans les thyristors T1 ou T2 en fin d'alternance. Cela est dû au fait que la charge ne requiert pas d'énergie pendant toute la période d'alimentation. L'un des thyristors est cependant amorcé en toute fin d'alternance (zone identifiée par la flèche 15) puis se bloque lorsque le condensateur C1 est déchargé au niveau VCC.

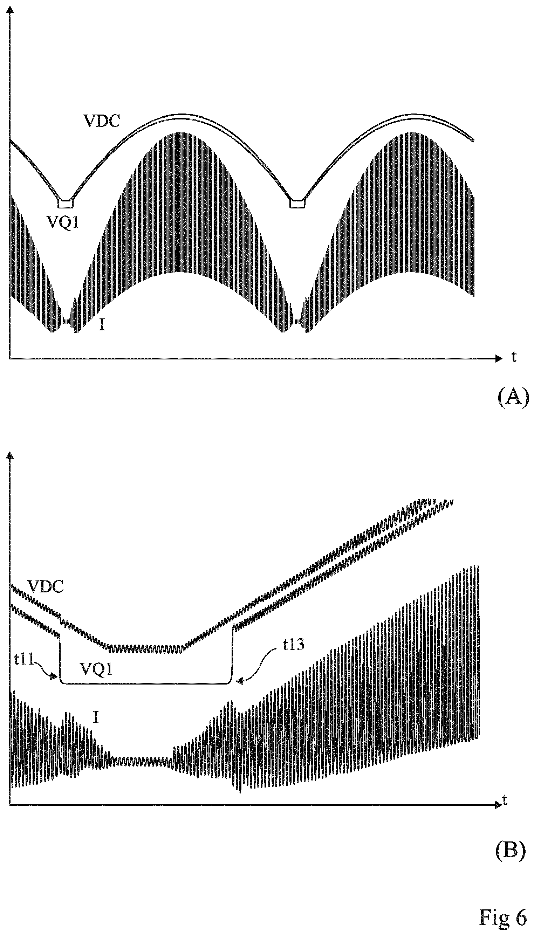

La figure 6 illustre, par des vues (A) et (B), le fonctionnement du convertisseur de la figure 3 pour une tension Vac de 110 volts et une fréquence de 50 Hz, et une charge de 100 %, c'est-à-dire que la charge absorbe une puissance égale à la valeur nominale du convertisseur.

La vue (A) représente deux alternances de la tension Vac tandis que la vue (B) est un agrandissement au voisinage du passage par zéro de la tension VDC.

Par rapport à la situation de la figure 6, comme la charge consomme ici en permanence, le thyristor T1 ou T2 amorcé au début d'une alternance reste passant jusqu'à la fin de l'alternance (partie gauche de la vue (B)).

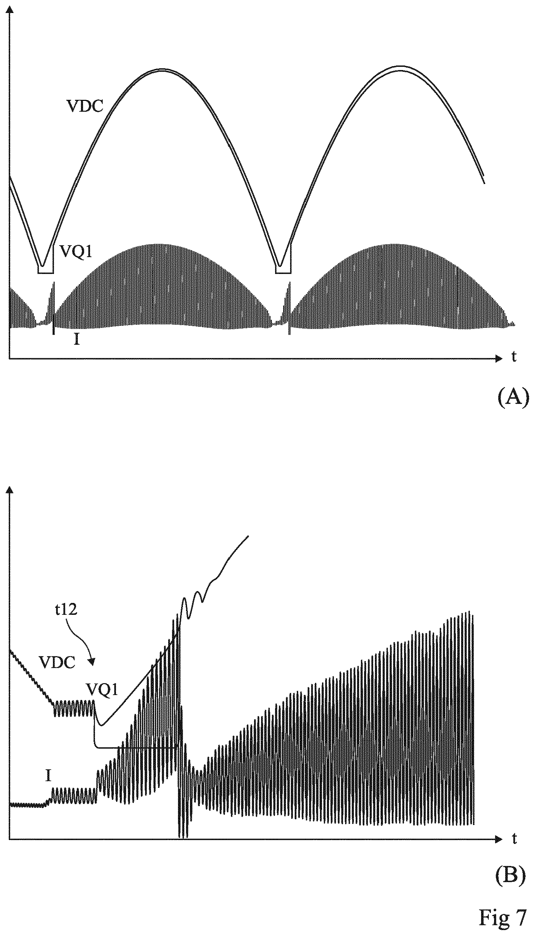

La figure 7 illustre, par des vues (A) et (B), le fonctionnement du convertisseur de la figure 3 pour une tension Vac de 230 volts et une fréquence de 50 Hz, et une charge de 50 %, c'est-à-dire que la charge absorbe une puissance égale à 50 % de la valeur nominale du convertisseur.

La vue (A) représente deux alternances de la tension Vac tandis que la vue (B) est un agrandissement au voisinage du passage par zéro de la tension VDC.

Dans cette situation, le transistor Q1 n'est pas rendu passant à la fin d'une alternance mais n'est rendu passant qu'au début de l'alternance suivante (instant t12), afin de ne commander le transistor Q1 qu'au moment opportun, c'est-à-dire lorsque la tension Vac recommence à croître, ce qui permet également au courant de cathode d'atteindre plus rapidement le seuil de verrouillage, par rapport à l'instant initial du début de conduction du transistor Q1. Ce retard d'amorçage du transistor Q1 permet de réduire son temps de conduction à la fraction utile (la durée entre l'instant t11 et le moment où VDC devient supérieure au plateau VCC est en effet inutile) et donc de réduire la dissipation de puissance dans la résistance R3.

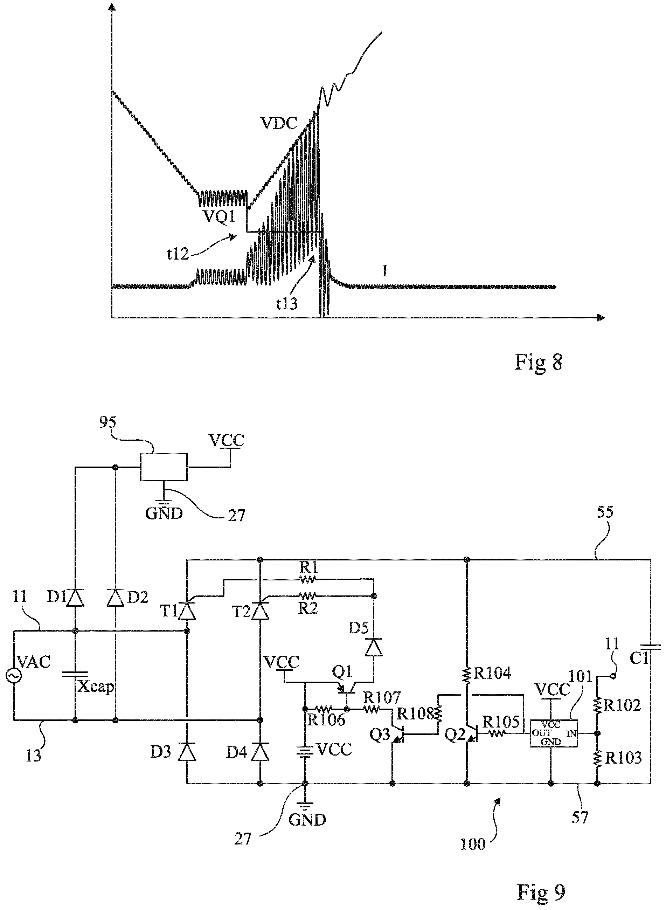

La figure 8 illustre le fonctionnement du convertisseur de la figure 3 pour une tension Vac de 230 volts et une fréquence de 50 Hz, et une charge de 25 %, c'est-à-dire que la charge Q absorbe une puissance égale à 25 % de la valeur nominale du convertisseur.

La représentation de la figure 8 est un agrandissement au voisinage du passage par zéro de la tension VDC.

Cette situation représente une situation extrême où, bien que la décharge du condensateur C1 forcée par le transistor Q1 entre les instants t12 et t13 permette la génération d'un courant de gâchette et l'amorçage d'un des thyristors, la faible consommation de la charge engendre une réduction du courant I en dessous du seuil de verrouillage du thyristor et, par voie de conséquence, le blocage du thyristor lorsque le courant de gâchette s'annule et ce jusqu'à la fin de la demi-alternance. La résistance Ricl assure alors la continuité de fourniture du courant depuis la tension Vac au convertisseur.

La figure 9 représente une variante d'un convertisseur.

Selon cette variante :
un condensateur alternatif Xcap relie, de préférence connecte, les bornes 11 et 13 et constitue le filtre alternatif ;
le transistor Q1 est commandé à partir d'un montage permettant d'assurer le retard de son impulsion de commande appliquée afin d'assurer le fonctionnement décrit à la figure 7 ; et
la résistance Ricl est supprimée.

La tension VCC, qui ne peut être fournie au démarrage par la résistance Ricl est alors fournie par un convertisseur auxiliaire 95, de préférence isolé, dont une borne d'entrée est reliée, de préférence connectée, à la cathode commune des diodes D1 et D2, et dont une borne de sortie fournit la tension VCC, le convertisseur 95 s'autoalimentant à partir de la tension VCC qu'il génère.

Une fois que la tension VCC est générée, les thyristors T1 et T2 sont commandés avec un retard à l'amorçage (avec un retard progressivement réduit) afin d'assurer la charge progressive du condensateur C1 (s'il est présent) et des autres condensateurs situés en aval du circuit de correction du facteur de puissance (par exemple le condensateur C, figure 4).

Cette commande est assurée par un montage 100 qui comporte :
un circuit 101 de détection du passage par zéro de la tension Vac, dont une borne d'entrée IN est reliée au point milieu d'un pont diviseur résistif constitué de résistances R102 et R103 en série entre la borne 11 (ou la borne 13, ou les deux via un redresseur) et la masse 27, le circuit 101 étant alimenté par la tension VCC, entre des bornes VCC et GND ;
un transistor bipolaire Q2, de type NPN, dont le collecteur est relié à la borne 55 par une résistance R104 et dont l'émetteur est relié, de préférence connecté, à la masse 27, la base du transistor Q2 étant reliée, par une résistance R105, à une borne de sortie OUT du circuit 101 ; et
un transistor bipolaire Q3, de type NPN, dont le collecteur est relié, par une résistance R107, à la base du transistor Q1 et dont l'émetteur est relié, de préférence connecté, à la masse 27, la base du transistor Q2 étant reliée, par une résistance R108, à la borne de sortie OUT du circuit 101.

Le transistor Q1 est ici un transistor PNP dont le collecteur est relié, de préférence connecté, à l'anode de la diode D5, dont l'émetteur reçoit la tension VCC et dont la base est reliée au point milieu d'une association en série d'une résistance R106 et de la résistance R107 entre le collecteur du transistor Q3 et la borne de fourniture de la tension VCC.

Le transistor Q1 permet de commander les thyristors T1 et T2 au voisinage du zéro de la tension secteur en régime permanent ou avec un retard par rapport à cet instant de passage par zéro de la tension Vac, détecté par le circuit 101. Les impulsions de commande des transistors Q3 (et donc Q1) et Q2 peuvent être de durée variable pendant la phase de démarrage, d'une demi-alternance à l'autre, et d'une durée différente en régime permanent.

On peut alors tirer profit de la présence des commutateurs Q1 et Q2 pour, lors d'une disparition de la tension Vac, décharger le condensateur Xcap en fermant, en continu, l'interrupteur Q1 et les thyristors T1 et T2.

Une telle décharge est souhaitable pour des questions de sécurité électrique.

Un avantage des modes de réalisation décrits est que leur mise en oeuvre ne requiert pas d'alimentation auxiliaire autre que pour le mode de réalisation de la figure 3 celle déjà disponible pour alimenter le circuit 9' de commande du circuit de correction du facteur de puissance.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, la solution présentée pour commander le commutateur Q1 au voisinage du passage par zéro de la tension VDC n'est qu'un exemple et d'autres solutions, par exemple utilisant le microcontrôleur du circuit de correction du facteur de puissance, pourront être prévues. Par ailleurs, bien que l'on ait décrit des modes de réalisation basés sur des ponts double alternance, ces modes de réalisation se transposent, sans difficulté, à un circuit de redressement mono alternance.

Enfin, la mise en oeuvre pratique des modes de réalisation et variantes décrits est à la portée de l'homme du métier à partir des indications fonctionnelles données ci-dessus. En particulier, le choix de la durée et du retard du créneau de commande en fermeture du transistor Q1 en fonction de l'application considérée dépend de l'application et est déterminable à partir de la description ci-dessus.

## Revendications

1. Circuit (1) comportant :
un pont redresseur (3) ayant au moins un premier thyristor (T1, T2) en série avec un premier élément de redressement (D3, D4) entre une première borne (25) et une deuxième borne de sortie redressée (27) du pont, **caractérisé en ce que** le circuit comprend au moins une diode (D5) en série avec une source de tension continue (8) entre une gâchette du thyristor et ladite deuxième borne (27).

2. Circuit selon la revendication 1, comportant en outre un commutateur (Q1) relié entre lesdites bornes de sortie (25, 27) .

3. Procédé de commande d'un circuit selon la revendication 2 comportant une étape de mise en conduction du commutateur (Q1) au rythme des alternances de la tension alternative (Vac).

4. Circuit selon la revendication 2, ou procédé selon la revendication 3, dans lequel le commutateur (Q1) est mis en conduction au voisinage des passages par zéro d'une tension alternative (Vac) appliquée à l'entrée du pont redresseur (3).

5. Circuit ou procédé selon la revendication 4, dans lequel la mise en conduction du commutateur (Q1) est déclenchée lorsque la tension alternative (Vac) descend en dessous d'une valeur supérieure à la tension continue fournie par ladite source (8).

6. Circuit ou procédé selon la revendication 4, dans lequel la mise en conduction du commutateur (Q1) est déclenchée avec retard par rapport au moment où la tension alternative (Vac) descend en dessous d'une valeur supérieure à la tension continue fournie par ladite source (8).

7. Circuit selon la revendication 1, 2, 4 à 6, ou procédé selon l'une quelconque des revendications 3 à 6, dans lequel une première résistance (R1, R2) relie une cathode de ladite diode (D5) à la gâchette dudit premier thyristor (T1, T2).

8. Circuit ou procédé selon la revendication 7, dans lequel un deuxième thyristor (T2, T1) du pont redresseur (3), en série avec un deuxième élément de redressement (D1, D2) entre lesdites bornes de sortie (25, 27), a sa gâchette reliée à ladite diode (D5) par l'intermédiaire d'une deuxième résistance (R2).

9. Circuit selon l'une quelconque des revendications 1, 2, ou 4 à 8, ou procédé selon l'une quelconque des revendications 3 à 8, dans lequel un circuit (5) de correction du facteur de puissance est relié auxdites bornes de sortie (25, 27).

10. Circuit selon l'une quelconque des revendications 1, 2, ou 4 à 9, ou procédé selon l'une quelconque des revendications 3 à 9, dans lequel un condensateur (C1) relie lesdites bornes de sortie (25, 27) du pont.

11. Circuit selon l'une quelconque des revendications 1, 2, ou 4 à 10, ou procédé selon l'une quelconque des revendications 3 à 10, dans lequel une résistance (Ricl) de limitation du courant d'appel est court-circuitable par ledit ou lesdits thyristors (T1, T2).

12. Circuit selon l'une quelconque des revendications 1, 2 ou 4 à 11, ou procédé selon l'une quelconque des revendications 3 à 11, dans lequel un condensateur alternatif (Xcap) relie deux bornes (11, 13) d'entrée du pont redresseur (3).

13. Circuit ou procédé selon l'une quelconque des revendications 4 à 12, dans lequel un circuit de décharge adapté à décharger le condensateur alternatif (Xcap) par l'intermédiaire d'au moins le commutateur (Q1) est mis en conduction lorsqu'une déconnection de la tension alternative (Vac) est détectée.

14. Convertisseur de puissance comportant un circuit selon l'une quelconque des revendications 1, 2, ou 4 à 13.

15. Convertisseur selon la revendication 14, comportant en outre un circuit (5) de correction du facteur de puissance.

## Patentansprüche

1. Eine Schaltung (1), die Folgendes aufweist:
eine Gleichrichterbrücke (3) mit mindestens einem ersten Thyristor (T1, T2) in Reihe mit einem ersten Gleichrichterelement (D3, D4) zwischen einem ersten Anschluss (25) und einem zweiten gleichgerichteten Ausgangsanschluss (27) der Brücke, **dadurch gekennzeichnet, dass** die Schaltung Folgendes aufweist
mindestens eine Diode (D5) in Reihe mit einer Gleichspannungsquelle (8) zwischen einem Gate des Thyristors und dem zweiten Anschluss (27).

2. Schaltung nach Anspruch 1, ferner aufweisend einen Schalter (Q1), der zwischen den Ausgangsanschlüssen (25, 27) verbunden ist.

3. Verfahren zur Steuerung der Schaltung nach Anspruch 2, das einen Schritt des Einschaltens des Schalters (Q1) im Takt der Halbwellen der Wechselspannung (Vac) aufweist.

4. Schaltung nach Anspruch 2 oder Verfahren nach Anspruch 3, wobei der Schalter (Q1) in der Nähe der Nulldurchgänge einer am Eingang der Gleichrichterbrücke (3) anliegenden Wechselspannung (Vac) eingeschaltet wird.

5. Schaltung oder Verfahren nach Anspruch 4, wobei das Einschalten des Schalters (Q1) ausgelöst wird, wenn die Wechselspannung (Vac) unter einen Wert fällt, der größer ist als die von der Quelle (8) gelieferte Gleichspannung.

6. Schaltung oder Verfahren nach Anspruch 4, wobei das Einschalten des Schalters (Q1) mit einer Zeitverzögerung ausgelöst wird, wenn die Wechselspannung (Vac) unter einen Wert fällt, der größer ist als die von der Quelle (8) gelieferte Gleichspannung.

7. Schaltung nach Anspruch 1, 2, 4 bis 6 oder das Verfahren nach einem der Ansprüche 3 bis 6, wobei ein erster Widerstand (R1, R2) eine Kathode der Diode (D5) mit dem Gate des ersten Thyristors (T1, T2) verbindet.

8. Schaltung oder Verfahren nach Anspruch 7, wobei ein zweiter Thyristor (T2, T1) der Gleichrichterbrücke (3) in Reihe mit einem zweiten Gleichrichterelement (D1, D2) zwischen den Ausgangsanschlüssen (25, 27) mit seinem Gate über einen zweiten Widerstand (R2) mit der Diode (D5) verbunden ist.

9. Schaltung nach einem der Ansprüche 1, 2 oder 4 bis 8 oder Verfahren nach einem der Ansprüche 3 bis 8, wobei eine Leistungsfaktorkorrekturschaltung (5) mit den Ausgangsanschlüssen (25, 27) verbunden ist.

10. Schaltung nach einem der Ansprüche 1, 2 oder 4 bis 9 oder Verfahren nach einem der Ansprüche 3 bis 9, wobei ein Kondensator (C1) die Ausgangsanschlüsse (25, 27) der Brücke verbindet.

11. Schaltung nach einem der Ansprüche 1, 2 oder 4 bis 10 oder Verfahren nach einem der Ansprüche 3 bis 10, wobei ein Einschaltstrombegrenzungswiderstand (Ricl) durch den Thyristor oder die Thyristoren (T1, T2) überbrückt werden kann.

12. Schaltung nach einem der Ansprüche 1, 2 oder 4 bis 11 oder Verfahren nach einem der Ansprüche 3 bis 11, wobei ein Wechselstromkondensator (Xcap) zwei Eingangsanschlüsse (11, 13) der Gleichrichterbrücke (3) verbindet.

13. Schaltung oder Verfahren nach einem der Ansprüche 4 bis 12, wobei eine Entladeschaltung, die in der Lage ist, den Wechselstromkondensator (Xcap) über mindestens den Schalter (Q1) zu entladen, eingeschaltet wird, wenn eine Unterbrechung der Wechselspannung (Vac) erkannt wird.

14. Stromwandler, der eine Schaltung nach einem der Ansprüche 1, 2 oder 4 bis 13 aufweist.

15. Stromwandler nach Anspruch 14, der ferner eine Leistungsfaktorkorrekturschaltung (5) aufweist.

## Claims

1. A circuit (1) comprising:
a rectifying bridge (3) having at least one first thyristor (T1, T2) in series with a first rectifying element (D3, D4) between a first terminal (25) and a second rectified output terminal (27) of the bridge, **characterized in that** the circuit comprises
at least one diode (D5) in series with a DC voltage source (8) between a gate of the thyristor and said second terminal (27).

2. The circuit according to claim 1, further comprising a switch (Q1) coupled between said output terminals (25, 27).

3. A method of controlling the circuit according to claim 2 comprising a step of turning on the switch (Q1) at the rate of the halfwaves of the AC voltage (Vac).

4. The circuit according to claim 2 or the method according to claim 3, wherein the switch (Q1) is turned on in the vicinity of the zero crossings of an AC voltage (Vac) applied to the input of the rectifying bridge (3).

5. The circuit or method according to claim 4, wherein the turning on of the switch (Q1) is triggered when the AC voltage (Vac) falls below a value greater than the DC voltage delivered by said source (8).

6. The circuit or method according to claim 4, wherein the turning on of the switch (Q1) is triggered with a delay with respect to the time when the AC voltage (Vac) falls below a value greater than the DC voltage delivered by said source (8).

7. The circuit according to claim 1, 2, 4 to 6 or the method according to any of claims 3 to 6, wherein a first resistor (R1, R2) couples a cathode of said diode (D5) to the gate of said first thyristor (T1, T2).

8. The circuit or method according to claim 7, wherein a second thyristor (T2, T1) of the rectifying bridge (3), in series with a second rectifying element (D1, D2) between said output terminals (25, 27), has its gate coupled to said diode (D5) via a second resistor (R2).

9. The circuit according to any of claims 1, 2, or 4 to 8, or the method according to any of claims 3 to 8, wherein a power factor correction circuit (5) is coupled to said output terminals (25, 27).

10. The circuit according to any of claims 1, 2, or 4 to 9, or the method according to any of claims 3 to 9, wherein a capacitor (C1) couples said output terminals (25, 27) of the bridge.

11. The circuit according to any of claims 1, 2, or 4 to 10, or the method according to any of claims 3 to 10, wherein an inrush current limiting resistor (Ricl) is capable of being bypassed by said thyristor(s) (T1, T2).

12. The circuit according to any of claims 1, 2, or 4 to 11, or the method according to any of claims 3 to 11, wherein an AC capacitor (Xcap) couples two input terminals (11, 13) of the rectifying bridge (3).

13. The circuit or method according to any of claims 4 to 12, wherein a discharge circuit capable of discharging the AC capacitor (Xcap) via at least the switch (Q1) is turned on when a disconnection of the AC voltage (Vac) is detected.

14. A power converter comprising the circuit according to any of claims 1, 2, or 4 to 13.

15. The converter according to claim 14, further comprising a power factor correction circuit (5).
